# EUROPÄISCHE PATENTANMELDUNG

(11) **EP 4 568 439 A1**
(43) Veröffentlichungstag der Anmeldung: **11.06.2025**
(21) Anmeldenummer: 24202503.9
(22) Anmeldetag: 25.09.2024
(51) Int. Cl.: H05K 9/00

(54) **VERFAHREN ZUM SICHERSTELLEN DER ELEKTRISCHEN ABSCHIRMUNG EINES GERÄTEGEHÄUSES**

(30) Priorität: 06.12.2023 DE 102023134138
(71) Anmelder: Pontis EMC GmbH, 92521 Schwarzenfeld (DE)
(72) Erfinder: Böhm, Erich, 92224 Amberg (DE)
(74) Vertreter: Glück Kritzenberger Patentanwälte PartGmbB

(57) **Zusammenfassung**

Die Erfindung betrifft ein Verfahren zum Sicherstellen der elektrischen Abschirmung eines Gerätegehäuses (10) beim Bearbeiten,
welches Gerätegehäuse (10) ein stirnseitig mit einem Gehäusedeckel (14) verschlossenes Hohlprofil (12) aufweist, die beide elektrisch leitend sind,
welcher Gehäusedeckel (14) einen Ringfortsatz (16) aufweist, der einen dickenreduzierten Abschnitt (18) am Ende des Hohlprofils (12) umgreift,
wobei die Höhe (h) des Ringfortsatzes (16) kleiner als die Höhe (H) des dickenreduzierten Abschnitts (18) ist, so dass die Stirnseite des dickenreduzierten Abschnitts (18) die Deckelinnenseite kontaktiert und zwischen dem freien Ende des Ringfortsatzes (16) und einem Absatz (20) am Beginne des dickenreduzierten Abschnitts (18) ein Abstand (a) verbleibt, wobei zum Bearbeiten des Gerätegehäuses (10) ein Bearbeitungsdeckel (30) verwendet wird, der ebenfalls einen Ringfortsatz (32) aufweist, wobei die Höhe (h₂) des Ringfortsatzes (32) des Bearbeitungsdeckels (30) größer als die Höhe (H) des dickenreduzierten Abschnitts (18) gewählt wird, so dass er beim Lackieren an dem Absatz (20) am Beginn des dickenreduzierten Abschnitt (18) des Hohlprofils (12) anliegt.

## Beschreibung

Die vorliegende Erfindung betrifft ein Verfahren zum Sicherstellen der elektrischen Abschirmung eines Gerätegehäuses beim Bearbeiten, insbesondere beim Lackieren. Elektronische Baugruppen und elektrische Schaltkreise von Geräten strahlen im Betrieb üblicherweise elektromagnetische Wellen ab, die durch das Gerätegehäuse sicher abgeschottet werden sollen. Es gibt vor allem Einsatzgebiete, bei denen eine Abstrahlung durch die dort verwendeten Geräte absolut unerwünscht ist, so zum Beispiel in Messeinrichtungen für die elektromagnetische Verträglichkeit (EMV). Aus diesem Grund werden bei dort eingesetzten Geräten Gerätegehäuse aus einem elektrisch leitenden Material verwendet, so dass die Geräte quasi in einem Faraday'schen Käfig angeordnet sind, wodurch die Abstrahlung verhindert wird. In der Regel besteht das Gehäuse aus Metall, meist aus Aluminium.

Ein kritischer Bereich für den Austritt von Strahlung besteht an Verbindungsstellen, an denen unterschiedliche Teile des Gehäuses zusammengesetzt werden.

In der Regel umfasst das Gehäuse für derartige strahlungssensitive Anwendungen ein Hohlprofil und einen Gehäusedeckel. Die Verbindungskante zwischen diesen beiden Gehäusekomponenten ist ein möglicher Ort für den Austritt von Strahlung, insbesondere in dem Bereich, in welchem der Gehäusedeckel an dem stirnseitigen Ende des Hohlprofils anliegt. Selbst ein kleinster Abstand an dieser Kante kann zum Austritt von Strahlung führen. Es gibt daher unterschiedliche Konzepte, den Strahlenaustritt an diesen Stellen zu verhindern, so zum Beispiel die Verwendung von vielen Befestigungsschrauben, so dass der Abstand zwischen dem Gehäusedeckel und dem freien Ende des Hohlprofils kleiner gehalten wird als ein Viertel der Wellenlänge der abzuhaltenden Strahlung. Alternativ oder zusätzlich kann eine elektrisch leitende Dichtung zwischen dem Gehäusedeckel und dem Hohlprofil eingelegt werden. Schließlich wird eine Überlappung der Kontaktfläche von Gehäusedeckel beabsichtigt, so dass die Kontaktfläche zwischen dem Gehäusedeckel und dem Hohlprofil möglichst groß ist. Das ist beispielsweise möglich, wenn der Gehäusedeckel einen Ringfortsatz aufweist, der innenseitig oder außenseitig die Stirnseite des Hohlzylinders umgreift.

Erfindungsgemäß wird eine Lösung verwendet, bei welcher das Hohlprofil, in der Regel ein Strangpress oder Gussprofil, im Bereich seiner Stirnseite einen von außen her dickenreduzierten Abschnitt aufweist, der sich über eine gewisse Länge des Hohlprofils erstreckt. Der die Deckelkante bildende Ringfortsatz des Gehäusedeckels umgreift dann diesen dickenreduzierten Abschnitt des Hohlprofils. Die Kontaktfläche zwischen Gehäusedeckel und Hohlprofil liegt damit im Überlappungsbereich zwischen dem Ringfortsatz und dem dickenreduzierten Abschnitt des Hohlprofils. Eine zweite Kontaktfläche wird gebildet an der Stirnseite des Hohlprofils, welche die Deckelinnenseite kontaktiert, was dadurch sichergestellt wird, dass die Höhe des Ringfortsatzes maximal so groß, vorzugsweise geringer ist als die Höhe des dickenreduzierten Abschnitts. Dies hat zur Folge, dass zwischen dem freien Ende des Ringfortsatzes und dem Absatz, der an dem Beginn des dickenreduzierten Abschnitt gebildet ist, ein Abstand verbleibt. Dieser Abstand stellt sicher, dass die Stirnseite des Hohlprofils an der Deckelinnenseite anliegen kann. Auf diese Weise werden zwei hintereinander geschaltete Kontaktflächen gebildet, wodurch ein Strahlendurchtritt durch das Gehäuse sehr effizient unterbunden werden kann.

Um diesen elektrischen Kontakt auch während der Bearbeitung des Gerätegehäuses, insbesondere beim Lackieren sicherzustellen, wird ein Bearbeitungsdeckel verwendet, der in gleicher Weise wie der normale Gehäusedeckel einen Ringfortsatz aufweist, der konzipiert ist, in einer Bearbeitungsstellung den dickenreduzierten Abschnitt des Hohlprofils zu umgreifen und eng an diesem anzuliegen. Im Gegensatz zum Gehäusedeckel ist jedoch beim Bearbeitungsdeckel die Höhe des Ringfortsatzes größer als die Höhe des dickenreduzierten Abschnitts, so dass der Ringfortsatz beim Lackieren an dem Absatz anliegt, welcher am Beginn des dickenreduzierten Abschnitts, d.h. an dem Übergang von der normalen Wandung des Hohlprofils zum dickenreduzierten Abschnitt ausgebildet ist. Auf diese Weise werden durch den Bearbeitungsdeckel beim Bearbeiten, insbesondere beim Lackieren alle Kontaktflächen des Hohlprofils geschützt und deren Kontaktfähigkeit wird somit während der Bearbeitung des Hohlprofils nicht beeinträchtigt, z.B. durch Farbnebel. Nach der Bearbeitung wird der Bearbeitungsdeckel wieder abgenommen und der Gehäusedeckel wird mit dem fertig bearbeiteten, insbesondere lackierten oder passivierten Hohlprofil verbunden.

Der dickenreduzierte Abschnitt wird vorzugsweise durch Fräsen von der Außenseite des Hohlprofils her erzeugt, so dass sehr definierter Außenabmessungen, d.h. Abstände der einander abgewandten Außenseiten des dickenreduzierten Abschnitts an den gegenüberliegenden Wänden des Hohlprofils erzielt werden, was dazu führt, dass der Ringfortsatz des exakt gearbeiteten Gehäusedeckels dann auch kontaktierend und flächig an der Kontaktfläche am Außenumfang des dickenreduzierten Abschnitts anliegt, wodurch eine sicher abschirmende erste Kontaktfläche erzielt wird.

Vorzugsweise ist die Höhe des Ringfortsatzes des Bearbeitungsdeckels größer als die Höhe des dickenreduzierten Abschnitts, so dass in Bearbeitungsstellung der Bearbeitungsdeckel von dem freien Ende des dickenreduzierten Abschnitts des Hohlprofils beabstandet ist. Dies führt dazu, dass durch den Bearbeitungsdeckel das freie Ende des dickenreduzierten Abschnitts des Hohlprofils, welches ja mit der Deckelinnenseite die zweite Kontaktfläche bildet, nicht verunreinigt wird.

Vorzugsweise wird als Material für das Hohlprofil und den Gehäusedeckel Aluminium verwendet und das Verfahren wird beim Lackieren oder Passiveren oder Eloxieren des Gehäuses angewandt. Bei diesen Bearbeitungsschritten ist am leichtesten eine Beeinträchtigung der elektrischen Leitfähigkeit der Kontaktflächen des Hohlprofils möglich, so dass dort das erfindungsgemäße Verfahren wirkungsvoll zur Geltung kommt.

Vorzugsweise wird als Hohlprofil des Gerätegehäuses ein Gussprofil oder ein Strangpressprofil verwendet, welches insbesondere einen rechteckigen, insbesondere quadratischen, oder runden Querschnitt aufweist. Derartige Profile sind technisch leicht und in großem Umfang herstellbar und können zur Bildung des dickenreduzierten Abschnitts leicht von außen abgetragen werden. Das Hohlprofil kann auch an einer Stirnseite geschlossen sein, wodurch ein topfartiges Profil gebildet wird, welches nur einen Gehäusedeckel benötigt. Zum Verschließen eines durchgängig offenen Hohlprofils werden in der Regel zwei Gehäusedeckel benötigt.

Vorzugsweise erfolgt die elektrische Verbindung zwischen dem Hohlprofil und dem Gehäusedeckel durch einen mechanischen Kontakt zwischen der Außenseite des dickenreduzierten Abschnitts und der Innenseite des Ringfortsatzes des Gehäusedeckels, wodurch die erste Kontaktfläche gebildet wird, als auch zwischen der Deckelinnenseite des Gehäusedeckels und dem freien Ende des dickenreduzierten Abschnitts des Hohlprofils, wodurch die zweite Kontaktfläche gebildet wird. Auf diese Weise werden die beiden Kontaktflächen hintereinander geschaltet, womit sehr effektiv jegliche Streustrahlung verhindert wird, die durch die Kante zwischen Gehäusedeckel und Hohlprofil hindurchtreten könnte.

Die Erfindung betrifft weiterhin ein Gerätegehäuse, insbesondere für Geräte, welche elektrische oder elektronische Baugruppen aufweisen, die eine gewisse Strahlung abgeben. Das Gerätegehäuse weist ein stirnseitig mit wenigstens einem Gehäusedeckel verschlossenes Hohlprofil auf, wobei das Hohlprofil als auch der Gehäusedeckel elektrisch leitend sind. Das Hohlprofil kann beispielsweise auch ein einseitig geschlossenes topfartiges Profil sein, welches durch einen einzigen Gehäusedeckel verschlossen wird, oder es kann beidseitig offen sein, so dass beide Enden mit einem Gehäusedeckel verschlossen sind.

Der bzw. einer der Gehäusedeckel kann beispielsweise auch eine Ausnehmung zum Durchtritt von Leitungen oder für eine Kameraoptik aufweisen, wenn in dem Gehäuse eine Kamera angeordnet ist. Vorzugsweise bestehen das Hohlprofil als auch der Gehäusedeckel aus Metall, insbesondere Aluminium. Der Gehäusedeckel hat einen zu einer Deckelseite hin abstehenden Ringfortsatz als Deckelkante, welcher einen dickenreduzierten Abschnitt am Ende des Hohlprofils umgreift. Die Höhe des Ringfortsatzes ist dabei maximal so groß wie die Höhe des dickenreduzierten Abschnitts, insbesondere kleiner, so dass die Stirnseite dieses dickenreduzierten Abschnitts an der Deckelinnenseite kontaktierend anliegt und dort die zweite Kontaktfläche bildet. Die erste Kontaktfläche wird durch den engen Kontakt zwischen der Innenseite des Ringfortsatzes des Gehäusedeckels und der Außenseite des dickenreduzierten Abschnitts gebildet.

Dieses Gerätegehäuse ist durch ein oben beschriebenes Bearbeitungsverfahren bearbeitet worden, so dass bei der Bearbeitung die Kontaktflächen zwischen dem Hohlprofil und dem Gehäusedeckel nicht beeinträchtigt worden sind.

Im Falle das Gerätegehäuse aus Aluminium besteht, ist eine bevorzugte Bearbeitung insbesondere die Eloxierung des Gehäuses.

Die Erfindung betrifft ebenfalls eine Kamera, die in einem vorstehend ausgeführten Gerätegehäuse angeordnet ist.

Die Erfindung betrifft ebenfalls ein Set aus einem Gerätegehäuse für Geräte, welche elektrische oder elektronische Komponenten aufweisen, und einem Bearbeitungsdeckel, wobei das Gerätegehäuse ein stirnseitig mit wenigstens einem Gehäusedeckel verschlossenes Hohlprofil aufweist. Sowohl das Hohlprofil als auch der Gehäusedeckel sind elektrisch leitend. Das Hohlprofil kann ein durchgängig offenes Hohlprofil sein oder es kann einseitig geschlossen sein und dadurch ein topfartiges Hohlprofil bilden. Der Gehäusedeckel hat einen zu einer Deckelseite hin abstehenden Ringfortsatz, der quasi die Deckelkante bildet. Dieser Ringfortsatz umgreift einen dickenreduzierten Abschnitt am Ende des Hohlprofils. Die Dickenreduzierung erfolgt hierbei von der Außenseite der Gehäusewandung des Hohlprofils, so dass der Ringfortsatz mit seiner Innenseite an der Außenseite des dickenreduzierten Abschnitts eng und kontaktierend anliegt. Die Höhe des Ringfortsatzes wird maximal so hoch wie, vorzugsweise kleiner als die Höhe des dickenreduzierten Abschnitts gewählt, so dass die Stirnseite dieses dickenreduzierten Abschnitts an der Deckelinnenseite kontaktierend anliegt und dort die zweite Kontaktfläche bildet.

Das Set enthält zudem einen Bearbeitungsdeckel zur Verwendung beim Bearbeiten, insbesondere beim Lackieren des Hohlprofils. Der Bearbeitungsdeckel weist wie der Gehäusedeckel einen Ringfortsatz auf, der konzipiert ist, in einer Bearbeitungsstellung den dickenreduzierten Abschnitt des Hohlprofils zu umfassen, wobei die Höhe des Ringfortsatzes des Bearbeitungsdeckels jedoch größer als die Höhe des dickenreduzierten Abschnitts ist. Auf diese Weise liegt das freie Ende des Ringfortsatzes des Bearbeitungsdeckels auf dem Absatz am Beginn des dickenreduzierten Abschnitts des Hohlprofils auf. Hierdurch wird durch den Bearbeitungsdeckel zum einen die die erste Kontaktfläche bildende Außenseite des dickenreduzierten Abschnitts komplett abgedeckt als auch die Stirnseite des dickenreduzierten Abschnitts, welche die zweite Kontaktfläche bildet. Somit werden diese Kontaktflächen nicht beim Bearbeiten in ihrer Leitfähigkeit beeinträchtigt, z.B. durch Farbnebel.

Vorzugsweise ist beim Gehäusedeckel die Höhe des Ringfortsatzes kleiner als die Höhe des dickenreduzierten Abschnitts, so dass zwischen dem freien Ende des Ringfortsatzes des Gehäusedeckels und dem Absatz am Beginn des dickenreduzierten Abschnitts des Hohlprofils ein Abstand verbleibt. Dies stellt sicher, dass die Stirnseite des dickenreduzierten Abschnitts des Hohlprofils kontaktierend an der Deckelinnenseite anliegen kann.

Es ist für den Fachmann offensichtlich, dass die oben beschriebenen Ausführungsformen der Erfindung in beliebiger Weise miteinander kombiniert werden können, solange sich Merkmale unterschiedlicher Ausführungsformen nicht einander widersprechen.

Folgende Ausdrücke werden synonym verwendet: Gerätegehäuse - Gehäuse;

Die Erfindung wird nachfolgend beispielsweise anhand der schematischen Zeichnung beschrieben. In dieser zeigen:
- Fig. 1: einen Längsschnitt durch ein Gerätegehäuse bestehend aus einem Hohlprofil mit einem stirnseitigen Gehäusedeckel nach dem Stand der Technik,
- Fig. 2: einen Längsschnitt durch ein Gerätegehäuse mit einem Hohlprofil und einem stirnseitigen Gehäusedeckel nach der vorliegenden Erfindung,
- Fig. 3: ein Detail III aus Fig. 2, und
- Fig. 4: einen Längsschnitt eines Gerätegehäuses mit einem Hohlprofil und einem Bearbeitungsdeckel zur Bearbeitung des Hohlprofils.

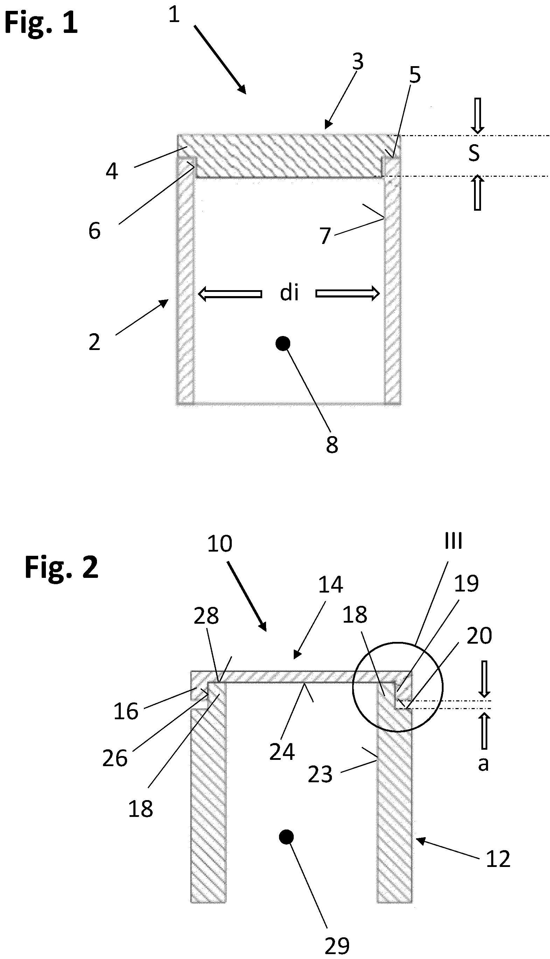

Fig. 1 zeigt ein Gerätegehäuse 1 nach dem Stand der Technik umfassend ein Hohlprofil 2, insbesondere aus Metall, auf welchem ein Gehäusedeckel 3 aus Metall aufgesetzt ist. Der Gehäusedeckel 3 hat eine dickenreduzierte Außenkante 4, die auf der Stirnseite 5 des Hohlprofils aufliegt. Zum anderen ist ein Absatz 6 zwischen dem Gehäusedeckelbereich seiner normalen Stärke S und der dickenreduzierten Kante 16 ausgebildet, der sich in axialer Richtung des Hohlprofils 2 erstreckt. Der Gehäusedeckel 3 liegt mit diesem Absatz 6 an der Innenwand 7 des Hohlprofils an und bildet dort den zweiten elektrischen Kontakt.

Der Nachteil an dieser Ausführungsform ist, dass aufgrund von Fertigungstoleranzen der Innendurchmesser di des Hohlprofils 12 schwanken kann, was dann dazu führt, dass der Absatz 6 des Gehäusedeckels 3 nicht eng und kontaktierend an der Innenwand 7 des Hohlprofils anliegt. Es würde dann nur noch eine Kontaktfläche zwischen der dickenreduzierten Außenkante 4 des Gehäusedeckels und der Stirnseite 5 des Hohlprofils verbleiben, die jedoch durch Verschmutzung oder beim Bearbeiten leicht beeinträchtigt werden kann. Diese Kante zwischen Hohlprofil 12 und Gehäusedeckel 14 bildet somit leicht einen Weg, damit Strahlung von der Gehäuseinnenseite 8 nach außen dringen kann.

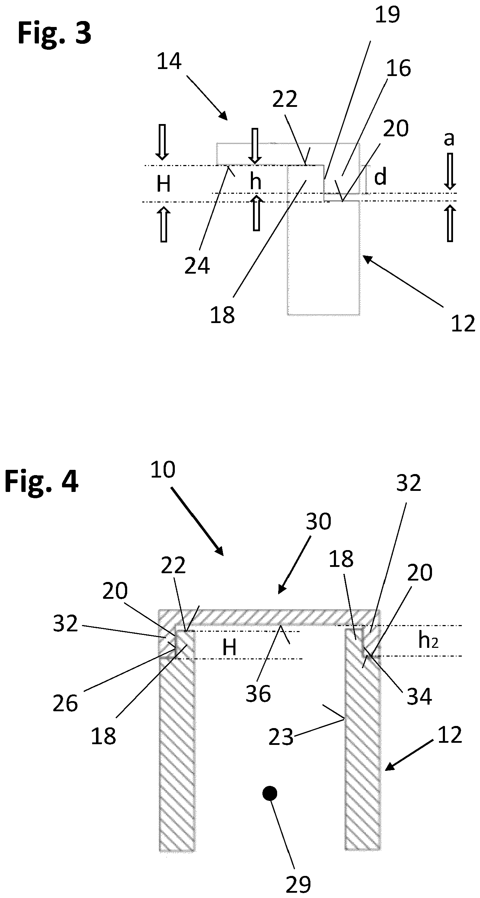

Fig. 2 und 3 zeigen eine erfindungsgemäße Form eines Gerätegehäuses 10, welches ebenfalls ein Hohlprofil 12 und einen Gehäusedeckel 14 umfasst. Das Hohlprofil 12 kann ein Gussprofil oder ein Strangpressprofil sein oder ein auf andere Weise hergestelltes Profil. Das Hohlprofil 12 kann auch an seiner Unterseite geschlossen sein, so dass das Hohlprofil topfartig wäre. Bei dem erfindungsgemäßen Gerätegehäuse hat der Gehäusedeckel 14 einen zum Hohlprofil weisenden Ringfortsatz 16, der den Deckelrand bildet. Dieser Ringfortsatz 16 umgreift einen dickenreduzierten Abschnitt 18 des Hohlprofils 16. Der dickenreduzierte Abschnitt 18 ist von der Gehäuseaußenseite her dickenreduziert, so dass sich außenseitig zwischen der normalen Gehäusewandung und dem dickenreduzierten Abschnitt 18 ein Absatz 20 erstreckt. Dieser dickenreduzierte Abschnitt 18 wird an seiner Außenseite 19 von dem ringförmigen Fortsatz 16 des Gehäusedeckels 14 enganliegend und kontaktierend in einem Überlappungsbereich d (Fig. 3) umgriffen. Die Höhe h des Ringfortsatzes 16 des Gehäusedeckels 14 ist maximal so hoch, insbesondere etwas kleiner, als die Höhe H des dickenreduzierten Abschnitts 18. Dies hat zur Folge, dass die Stirnseiten 22 des dickenreduzierten Abschnitts 18 an der Innenseite 24 des Gehäusedeckels anliegen. Dies hat zur Folge, dass in dem Überlappungsbereich d zwischen dem Ringfortsatz 16 und der Außenseite 19 des dickenreduzierten Abschnitt 18 eine erste Kontaktfläche 26 gebildet wird und zwischen der Stirnseite 22 des dickenreduzierten Abschnitts 18 und der Innenseite 24 des Gehäusedeckels 14 eine zweite Kontaktfläche 28. Diese beiden Kontaktflächen 26, 28 sind in Reihe geschaltet, wodurch jegliche Abstrahlung aus dem Innenraum 29 des Gerätegehäuses 10 nach außen durch die Kante zwischen dem Hohlprofil 12 und dem Gehäusedeckel 14 effektiv vermieden wird. Ein mit einem derartigen Gerätegehäuse 10 versehenes Gerät, wie zum Beispiel eine Kamera, kann somit auch in sehr strahlungssensitiven Bereichen, wie zum Beispiel einer Anordnung zum Messen der elektromagnetischen Empfindlichkeit eingesetzt werden.

Um die beiden Kontaktflächen 26, 28 während der Bearbeitung des Hohlprofils 12 des Gerätegehäuses 10, z.B. beim Lackieren oder Passivieren sicherzustellen, wird ein Bearbeitungsdeckel 30 verwendet, wie er in Fig. 4 dargestellt ist. In diesem Zusammenhang sei angemerkt, dass in allen Figuren identische Elemente oder funktionsgleiche Elemente mit den identischen Bezugszeichen versehen sind. Der Bearbeitungsdeckel 30 hat in gleicher Weise wie der Gehäusedeckel 14 einen Ringfortsatz 32, dessen Höhe h2 (in axialer Richtung des Hohlprofils 12) jedoch größer als die Höhe H des dickenreduzierten Abschnitts ist, so dass die freie Kante 34 des Ringfortsatzes auf dem Absatz 20 am Fuße des dickenreduzierten Abschnitts 18 des Hohlprofils 12 aufliegt. Dies führt dazu, dass die Stirnseite 22 des dickenreduzierten Abschnitts 18 von der Deckelinnenseite 36 des Bearbeitungsdeckels beabstandet ist. Somit wird durch den Bearbeitungsdeckel 30 sowohl die Außenseite 19 des dickenreduzierten Abschnitts 18 geschützt, welche den hohlprofilseitigen Teil der ersten Kontaktfläche 26 bildet, und zum anderen ist die Deckelinnenseite 36 des Bearbeitungsdeckels 30 von dem freien Ende 22 des dickenreduzierten Abschnitts 18 beabstandet, so dass diese zweite Kontaktfläche 28 durch den Bearbeitungsdeckel 30 nicht verschmutzt wird. Auf diese Weise werden somit beim Bearbeiten des Hohlprofils 12 die Außenseite des dickenreduzierten Abschnitts als auch deren Stirnseite wirkungsvoll geschützt, um somit die Leitfähigkeit beim Verbinden mit dem nach der Bearbeitung des Hohlprofils aufzusetzenden Gehäusedeckel 14 aufrechtzuerhalten.

Es ist für den Fachmann offensichtlich, dass die Erfindung nicht auf das dargestellte Ausführungsbeispiel beschränkt ist, sondern stattdessen innerhalb des Schutzbereichs der beigefügten Patentansprüche variiert werden kann.

### Bezugszeichenliste:

- 1: Gerätegehäuse nach dem Stand der Technik
- 2: Hohlprofil des Gerätegehäuses
- 3: Gehäusedeckel
- 4: dickenreduzierte Außenkante des Gehäusedeckels
- 5: Stirnseite des Hohlprofils
- 6: Absatz zwischen dem inneren Gehäusedeckelbereich und der dickenreduzierten Außenkante
- 7: Innenwand des Hohlprofils
- 8: Gehäuseinnenseite
- 10: Gerätegehäuse nach der Erfindung
- 12: Hohlprofil des Gerätegehäuses
- 14: Gehäusedeckel
- 16: der die Außenkante bildende und sich in Richtung auf das Hohlprofil erstreckende Ringfortsatz des Gehäusedeckels
- 18: dickenreduzierter Abschnitt des Hohlprofils im Bereich seines stirnseitigen Endes
- 19: Außenseite des dickenreduzierten Abschnitts
- 20: Absatz am Beginn des dickenreduzierten Abschnitts des Hohlprofils
- 22: stirnseitiges Ende des dickenreduzierten Abschnitts des Hohlprofils
- 24: Deckelinnenseite des Gehäusedeckels
- 26: erste Kontaktfläche zwischen der Außenseite des dickenreduzierten Abschnitts und der Innenseite des Ringfortsatzes des Gehäusedeckels
- 28: zweite Kontaktfläche zwischen der Stirnseite des dickenreduzierten Abschnitts des Hohlprofils und der Deckelinnenseite des Gehäusedeckels
- 29: Innenraum des Gerätegehäuses
- 30: Bearbeitungsdeckel zur Verwendung beim Bearbeiten des Hohlprofils, insbesondere beim Lackieren oder Passiveren
- 32: der die Deckelaußenkante bildende und sich in Richtung auf das Hohlprofil erstreckende Ringfortsatz des Bearbeitungsdeckels
- 34: freie untere Kante des Ringfortsatzes des Bearbeitungsdeckels
- 36: Deckelinnenseite des Bearbeitungsdeckels
- H: Höhe des dickenreduzierten Abschnitts des Hohlprofils
- h: Höhe des Ringfortsatzes des Gehäusedeckels
- h2: Höhe des Ringfortsatzes des Bearbeitungsdeckels
- a: Abstand zwischen dem Absatz am Beginn des dickenreduzierten Abschnitts und dem freien Ende des Ringfortsatzes des Gehäusedeckels

## Patentansprüche

1. Verfahren zum Sicherstellen der elektrischen Abschirmung eines Gerätegehäuses (10) beim Bearbeiten,
welches Gerätegehäuse (10) ein stirnseitig mit wenigstens einem Gehäusedeckel (14) verschlossenes Hohlprofil (12) aufweist, wobei sowohl das Hohlprofil (12) als auch der Gehäusedeckel (14) elektrisch leitend sind,
welcher Gehäusedeckel (14) als Deckelkante einen zu einer Deckelseite abstehenden Ringfortsatz (16) aufweist, der einen von der Außenseite her dickenreduzierten Abschnitt (18) am Ende des Hohlprofils (12) in einem Überlappungsbereich (d) umgreift,
wobei die Höhe (h) des Ringfortsatzes (16) kleiner als die Höhe (H) des dickenreduzierten Abschnitts (18) gewählt wird, so dass die Stirnseite des dickenreduzierten Abschnitts (18) an der Deckelinnenseite kontaktierend anliegt und zwischen dem freien Ende des Ringfortsatzes (16) und einem Absatz (20) am Beginn des dickenreduzierten Abschnitts (18) des Hohlprofils (12) ein Abstand (a) verbleibt, wobei zum Bearbeiten des Gerätegehäuses (10) ein Bearbeitungsdeckel (30) verwendet wird, der ebenfalls einen Ringfortsatz (32) aufweist, der in einer Bearbeitungsstellung den dickenreduzierten Abschnitt (18) des Hohlprofils (12) umgreift und eng an dem dickenreduzierten Abschnitt (18) des Hohlprofils (12) anliegt, wobei die Höhe (h₂) des Ringfortsatzes (32) des Bearbeitungsdeckels (30) größer als die Höhe (H) des dickenreduzierten Abschnitts (18) gewählt wird, so dass er beim Bearbeiten an dem Absatz (20) am Beginn des dickenreduzierten Abschnitts (18) des Hohlprofils (12) anliegt.

2. Verfahren nach Anspruch 1, **dadurch gekennzeichnet, dass** in Bearbeitungsstellung der Bearbeitungsdeckel (30) von dem freien Ende (22) des dickenreduzierten Abschnitts (18) des Hohlprofils (12) beabstandet ist.

3. Verfahren nach einem der vorhergehenden Ansprüche, **dadurch gekennzeichnet, dass** als Material für das Hohlprofil (12) und den Gehäusedeckel (14) Aluminium verwendet wird und dass das Verfahren beim Lackieren oder Passivieren/Eloxieren angewandt wird.

4. Verfahren nach einem der vorhergehenden Ansprüche, **dadurch gekennzeichnet, dass** als Hohlprofil (12) ein Gussprofil oder ein Strangpressprofil verwendet wird.

5. Verfahren nach einem der vorhergehenden Ansprüche, **dadurch gekennzeichnet, dass** der dickenreduzierte Abschnitt (18) gefräst wird.

6. Verfahren nach einem der vorhergehenden Ansprüche, **dadurch gekennzeichnet, dass** die elektrische Verbindung zwischen dem Hohlprofil (12) und dem Gehäusedeckel (14) durch eine erste Kontaktfläche (26) zwischen der Außenseite (19) des dickenreduzierten Abschnitts (18) und der Innenseite des Ringfortsatzes (16) als auch durch eine zweite Kontaktfläche (28) zwischen der Deckelinnenseite (24) und dem freien Ende (22) des dickenreduzierten Abschnitts (18) erfolgt.

7. Gerätegehäuse, welches Gerätegehäuse (10) ein stirnseitig mit wenigstens einem Gehäusedeckel (14) verschlossenes Hohlprofil (12) aufweist, wobei sowohl das Hohlprofil (12) als auch der Gehäusedeckel (14) elektrisch leitend sind,
welcher Gehäusedeckel (14) einen zu einer Deckelseite abstehenden Ringfortsatz (16) aufweist, der einen dickenreduzierten Abschnitt (18) am Ende des Hohlprofils (12) kontaktierend umgreift,
wobei die Höhe (h) des Ringfortsatzes (16) kleiner als die Höhe (H) des dickenreduzierten Abschnitts (18) gewählt wird, so dass die Stirnseite (22) des dickenreduzierten Abschnitts (18) an der Deckelinnenseite (24) kontaktierend anliegt, bearbeitet nach einem Verfahren gemäß einem der Ansprüche 1 bis 6.

8. Gerätegehäuse (10) nach Anspruch 7, **dadurch gekennzeichnet, dass** zwischen dem freien Ende des Ringfortsatzes (16) und dem Absatz (20) am Beginn des dickenreduzierten Abschnitts (18) des Hohlprofils (12) ein Abstand (a) verbleibt.

9. Gerätegehäuse (10) nach Anspruch 7 oder 8, bestehend aus Metall, insbesondere Aluminium.

10. Kamera, angeordnet in einem Gerätegehäuse (10) nach einem der Ansprüche 7 bis 9.

11. Set aus einem Gerätegehäuse (10) und einem Bearbeitungsdeckel (30), welches Gerätegehäuse (10) ein stirnseitig mit wenigstens einem Gehäusedeckel (14) verschlossenes Hohlprofil (12) aufweist, wobei sowohl das Hohlprofil (12) als auch der Gehäusedeckel (14) elektrisch leitend sind,
welcher Gehäusedeckel (14) einen zu einer Deckelseite abstehenden Ringfortsatz (16) aufweist, der einen dickenreduzierten Abschnitt (18) am Ende des Hohlprofils (12) umgreift,
wobei die Höhe des Ringfortsatzes (16) kleiner als die Höhe des dickenreduzierten Abschnitts (18) gewählt wird, so dass die Stirnseite (22) dieses dickenreduzierten Abschnitts (18) an der Deckelinnenseite (24) kontaktierend anliegt, und wobei der Bearbeitungsdeckel (30) zur Verwendung beim Bearbeiten, insbesondere beim Lackieren des Hohlprofils (12) ausgebildet ist und einen Ringfortsatz (32) aufweist, der konzipiert ist, in einer Bearbeitungsstellung den dickenreduzierten Abschnitt (18) des Hohlprofils (12) zu umgreifen, wobei die Höhe (h₂) des Ringfortsatzes (32) des Bearbeitungsdeckels (30) größer als die Höhe (H) des dickenreduzierten Abschnitts (18) ist.

12. Set nach Anspruch 11, bei dem zwischen dem freien Ende des Ringfortsatzes (14) und dem Absatz (20) am Beginn des dickenreduzierten Abschnitts (18) des Hohlprofils (12) ein Abstand (a) verbleibt.
